# EUROPÄISCHE PATENTSCHRIFT

(11) **EP 0 965 083 B1**
(45) Veröffentlichungstag und Bekanntmachung des Hinweises auf die Patenterteilung: **04.07.2001**
(21) Anmeldenummer: 98909304.2
(22) Anmeldetag: 30.01.1998
(51) Int. Cl.: G06F 11/20

(54) **DATENSPEICHER MIT EINER REDUNDANZSCHALTUNG**
MEMORY WITH REDUNDANCY CIRCUIT
MEMOIRE DE DONNEES A CIRCUIT REDONDANT

(30) Priorität: 05.03.1997 DE 19708965
(43) Veröffentlichungstag der Anmeldung: 22.12.1999
(73) Patentinhaber: Infineon Technologies AG, 81669 München (DE)
(72) Erfinder: ZETTLER, Thomas, D-81737 München (DE)
(74) Vertreter: Zedlitz, Peter, Dipl.-Inf.
(86) Internationale Anmeldenummer: DE9800274
(87) Internationale Veröffentlichungsnummer: WO9839708

(56) Entgegenhaltungen:
- WO-A-91/14227
- US-A- 4 376 300
- US-A- 5 357 463
- "FUSELESS NON-VOLATILE FERROELECTRIC REDUNDANT WORD AND BIT DECODER" IBM TECHNICAL DISCLOSURE BULLETIN, Bd. 34, Nr. 7B, 1.Dezember 1991, Seiten 138-140, XP000282528
- PASHLEY R D ET AL: "FLASH MEMORIES: THE BEST OF TWO WORLDS " IEEE SPECTRUM, Bd. 26, Nr. 12, 1.Dezember 1989, Seiten 30-33, XP000085217

## Beschreibung

Die Erfindung betrifft einen Datenspeicher, der die folgenden Merkmale aufweist:
- wenigstens ein Speicherzellenfeld, das Speicherzellen aufweist, wobei die Speicherzellen durch Anlegen wenigstens eines Selektionssignals an im Bereich der Speicherzellen vorgesehene Selektionsleitungen selektierbar sind, wobei die Selektionsleitungen Wortleitungen und/oder Bitleitungen umfassen können.
- eine Redundanzschaltung, die wenigstens eine RedundanzSpeicherzelle aufweist, wobei die Redundanzspeicherzellen durch Anlegen wenigstens eines Redundanz-Selektionssignals an im Bereich der Redundanz-speicherzellen vorgesehene Redundanz-Selektionsleitungen selektierbar sind, wobei die Redundanz-Selektionsleitungen Redundanzwortleitungen und/oder Redundanzbitleitungen umfassen können.
- eine Redundanz-Selektionsleitungsauswahlschaltung, die mindestens einen Zuordnungsspeicher aufweist, in dem eine Zuordnungsinformation abspeicherbar ist, wobei die Redundanz-Selektionsleitungsauswahlschaltung so ausgebildet ist, daß aufgrund der Zuordnungsinformation wenigstens eine Redundanz-Selektionsleitung zu wenigstens einer Selektionsleitung zuordenbar ist,
- der Zuordnungsspeicher weist zur Aufnahme der Zuordnungsinformation eine Zuordnungsspeicherzelle mit einem Zwischenspeicher auf,
- der Zuordnungsspeicher ist so ausgebildet, daß in einem Betriebsmodus des Datenspeichers die Zuordnungsinformation von der Zuordnungsspeicherzelle in den Zwischenspeicher übertragbar ist.

Datenspeicher und insbesondere Halbleiterdatenspeicher werden häufig auf die folgende Weise hergestellt. Zunächst wird eine Vielzahl von Datenspeichern auf einem Substratabschnitt erzeugt, der Wafer genannt wird. Nach der Herstellung des Wafers werden die einzelnen Datenspeicher getestet, und zwar insbesondere daraufhin, ob die Speicherzellen des Speicherzellenfelds und die Redundanzspeicherzellen der Redundanzschaltung ordnungsgemäß arbeiten. Dabei wird in jede Speicherzelle bzw. in jede Redundanzspeicherzelle wiederholt ein jeweils unterschiedlicher Wert geschrieben, wobei durch eine nachfolgende Leseoperation überprüft wird, ob die geprüfte Speicherzelle bzw. Redundanzspeicherzelle ordnungsgemäß beschrieben werden konnte. Falls eine defekte Speicherzelle ermittelt wird, so wird die Redundanz-Selektionsleitungsauswahlschaltung so programmiert, daß einer unbrauchbaren Speicherzelle eine ordnungsgemäß arbeitende Redundanzspeicherzelle zugeordnet wird. Dies erfolgt so, daß die zugeordnete Redundanzspeicherzelle die Funktion der als defekt erkannten Speicherzelle übernimmt. Aufgrund der besonderen Ausbildung der Redundanz-Selektionsleitungs auswahlschaltung kann eine zugeordnete Redundanzspeicherzelle so angesprochen werden, daß das Speicherzellenfeld von außen den Eindruck erweckt, ausschließlich ordnungsgemäß arbeitende Speicherzellen aufzuweisen.

In einem nachfolgenden Schritt wird der Wafer in einzelne Datenspeicher zersägt. Daraufhin werden die einzelnen Datenspeicher in Gehäuse montiert und erneut einem Test unterzogen, wobei erst danach die Auslieferung der gattungsgemäßen Datenspeicher erfolgt.

Die aus der US-A-5 200 922 bekannten gattungsgemäßen Datenspeicher haben Redundanz-Selektionsleitungsauswahlschaltungen, die statische Speicherzellen aufweisen, um eine Zuordnungsinformation abzuspeichern, aufgrund der im Betrieb eine Redundanzspeicherzelle einer defekten Speicherzelle zugeordnet wird. Zur Programmierung dieser Speicherzellen werden relativ hohe Spannungen benötigt, so daß bei den gattungsgemäßen Datenspeichern ein zusätzlicher Schaltungsaufwand erforderlich ist. Weiterhin sind je nach dem verwendeten Programmierverfahren beim Zuordnen von Redundanzspeicherzellen zu Speicherzellen relativ lange Programmierzeiten erforderlich. Dies ist besonders störend, weil beim Test der gattungsgemäßen Datenspeicher auch die Redundanzspeicherzellen auf ihre ordnungsgemäße Funktion hin überprüft werden müssen, was durch ein wiederholtes Umprogrammieren der Redundanzspeicherzellen erfolgt. Bei einer Vielzahl von Redundanzspeicherzellen summieren sich die Programmierzeiten auf, so daß die Überprüfung besonders zeitaufwendig ist. Mit der Überprüfung ist auch ein hoher Stromverbrauch verbunden. Weiterhin sind im Bereich der Zuordnungsspeicher vorgesehene Latches vorgesehen, in die beim Betrieb des gattungsgemäßen Datenspeichers Informationen aus den Zuordnungsspeichern geschrieben werden. Insgesamt sind die gattungsgemäßen Datenspeicher aufwendig in der Herstellung.

Es ist daher Aufgabe der Erfindung, einen Datenspeicher bereitzustellen, der einen einfachen Aufbau hat, bei dem scbnell, einfach und mit geringem Energieverbrauch Redundanz-speicherzellen zu defekten Speicherzellen zuordenbar sind.

Diese Aufgabe wird gemäß der Erfindung nach Patentanspruch 1 dadurch gelöst, daß der Zuordnungsspeicher so ausgebildet ist, daß in einem Programmiermodus des Datenspeichers die Zuordnungsinformation vom Zwischenspeicher in die Zuordnungsspeicherzelle übertragbar ist.

Dokument IBM TDB, Band 34, No. 7B, Dez. 1991, Seiten 138-140 offenbart sämtliche Merkmale des Oberbegriffs des Anspruchs 1.

Dabei ist insbesondere vorgesehen, daß die im Zwischenspeicher bzw. Latch abgespeicherte Information ein von außerhalb des Datenspeichers vorgegebener Wert ist, der auf ein besonderes Signal hin nichtflüchtig in die beispielsweise als Flash- oder EEPROM-Zelle ausgebildete Zuordnungsspeicherzelle übertragen wird. So ergibt sich eine Schaltung, die sowohl in einem Zustand "nichtflüchtiges Schatten RAM" (NVM Shadow RAM) als auch - bei alleiniger Nutzung des Latch - in einem Zustand "gewöhnliches RAM" betrieben werden kann. Der reine RAM-Betrieb erleichtert das Austesten der Komponenten des Datenspeichers wesentlich, während der NVM Shadow-Mechanismus die Einstellungen auch ohne externe Spannung erhält. Durch die erfindungsgemäße Ausbildung ergibt sich der weitere Vorteil, daß pro Bit des Zuordnungsspeichers nur eine einzige Zuordnungsspeicherzelle notwendig ist, die darüberhinaus auch besonders einfach zu programmieren ist.

Dabei ist in weiterer vorteilhafter Ausbildung der Erfindung vorgesehen, daß die nichtflüchtigen Zellen im Zuordnungsspeicher mit einer negativen Spannung am Control-Gate programmierbar sind. Dadurch ist der Zuordnungsspeicher nämlich besonders einfach innerhalb eines Flash-Speichers mit negativer Control-Gate-Programmierspannung zu realisieren.

In diesem Zusammenhang ist es weiterhin vorteilhaft, wenn der Datenspeicher so ausgebildet ist, daß die in der Zuordnungsspeicherzelle abgespeicherte Zuordnungsinformation beim erstmaligen Aktivieren des Datenspeichers in den Latch geschrieben wird, wobei im folgenden Betrieb nur noch auf die im Latch vorhandene Zuordnungsinformation zugegegriffen wird. Dann wird zum Betrieb des erfindungsgemäßen Datenspeichers nur ein sehr kleiner Strom benötigt, denn dadurch tritt nur einmal ein hoher Stromverbrauch auf, und zwar beim Auslesen des Zuordnungsspeichers beim Einschalten des Datenspeichers.

Für Testzwecke erweist sich die vorstehende Vorgehensweise als zeitsparend, da beim Speichertest und beim Zuordnen der Redundanz-Speicherzellen zu den Speicherzellen das schnell reagierende Latch eingesetzt wird, während die Zuordnungsinformation statisch in der Zuordnungsspeicherzelle abspeicherbar ist. Somit läßt sich auch die Redundanzzuordnung für Testzwecke schnell verändern, wobei ein als brauchbar gefundener Zuordnungszustand nach Testende aus den Latches dauerhaft in die Zuordnungsspeicherzelle geschrieben wird. Weiterhin ist von Bedeutung, daß insbesondere beim Ändern des Latch-Zustandes keine Hochspannung benötigt wird, was den Schaltungsaufwand ebenfalls vermindert.

Wenn die Zuordnungsspeicherzelle und/oder die Ansteuerschaltung für die Zuordnungsspeicherzelle so ausgebildet ist, daß sie insbesondere am Control Gate mit einer positiven Spannung löschbar und mit einer negativen Spannung programmierbar ist bzw. löscht und programmiert, dann kann sie besonders vorteilhaft in einer Wortleitungsredundanzschaltung im Zusammenhang mit Flash-Datenspeichern mit einer negativen Programmierspannung eingesetzt werden.

Vorteilhafterweise werden für die erfindungsgemäßen Zuordnungsspeicherzelle Flash-Speicherzellen verwendet, die unter Anwendung von Fowler-Nordheim-Tunnelströmen löschbar und programmierbar sind. Dies ist beispielsweise bei FLOTOX-EEPROMs bekannt und und diese Technik wird auch für Flash-Speicher insbesondere in der 0,5µm CMOS-Technik angewendet.

In vorteilhaften Ausbildungen sind die Zuordnungsspeicherzellen jeweils als Stacked-Gate-Zelle ausgebildet, die sich flächenqünstig herstellen lassen. Bei der Ausbildung der Zuordnungsspeicherzelle als Split-Gate-Zelle ergibt sich der Vorteil einer besonders einfachen Schaltung, die darüber hinaus verhindert, daß durch Prozeßschwankungen der Serien-Gate-Länge in Verbindung mit extremen over-erase-Effekten Leckströme entstehen.

Weiterhin ist wenigstens ein Adreßdecoder vorgesehen, der zwischen einen Adreßbus und die zu den Speicherzellen führenden Selektionsleitungen geschaltet ist', wobei der Adreßdecoder vorteilhafterweise so ausgebildet ist, daß eine oder mehrere Selektionsleitungen entsprechend einer am Adreßbus anliegenden Adresse selektierbar sind. Außerdem ist ein Redundanzadreßdecoder vorgesehen, der zwischen den Adreßbus und die Redundanz-Selektionsleitungen geschaltet ist, die zu den Redundanzspeicherzellen führen, wobei der Redundanzadreßdecoder so ausgebildet ist, daß eine oder mehrere Redundanz-Selektionsleitungen entsprechend einer am Adreßbus anliegenden Adresse selektierbar sind. Weiterhin ist die Redundanz-Selektionsleitungsauswahlschaltung bevorzugt im Bereich des Redundanzadreßdecoders angeordnet. Der wie vorstehend ausgebildete Datenspeicher erweist sich als besonders vorteilhaft, weil die Redundanz-Selektionsleitungsauswahlschaltung sowohl in einem Programmierungszustand, in dem die Redundanzspeicherzellen defekten Speicherzellen zugeordnet werden, als auch in einem Betriebszustand, in dem die entsprechenden Redundanzspeicherzellen defekte Speicherzellen ersetzen, einfach zu betreiben ist. Im Programmierungszustand erfährt dann nämlich die Redundanz-Selektionsleitungsauswahlschaltung von dem angeschlossenen Adreßbus die Adressen der jeweils zu ersetzenden Speicherzellen über die gleichen Adreßleitungen, über die im Betrieb auf die Redundanzspeicherzellen zugegriffen wird. Dadurch wird der Schaltungsaufwand beträchtlich vermindert.

Besonders vorteilhaft ist der erfindungsgemäße Datenspeicher mit einem Adreßdecoder ausgebildet, der durch den Redundanzadreßdecoder deaktivierbar ist. Dadurch wird ein fehlerhaftes Auslesen von Information verhindert, da in dem Fall, in dem auf eine Redundanzspeicherzelle zugegriffen wird, keinerlei Zugriff auf eine Speicherzelle erfolgt. Weiterhin erhöht sich die Zuverlässigkeit des Datenspeichers.

Darüberhinaus ist es besonders vorteilhaft, wenn der Datenspeicher die folgenden Merkmale aufweist:
- der Adreßbus ist als paralleler Adreßbus mit einer Anzahl von Adreßbusleitungen ausgebildet,
- der Zuordnungsspeicher weist Zuordnungsspeicherzellen auf, wobei die Anzahl der Zuordnungsspeicherzellen gleich der Anzahl der Adreßbusleitungen ist.

Dadurch ergibt sich eine einfache Decodierung der am Adreßbus anliegenden Adresse sowohl im Programmiermodus als auch im Arbeitsmodus des Zuordnungsspeichers des Datenspeichers. Vorteilhafterweise sind gleich mehrere der wie vorstehend ausgebildeten Zuordnungsspeicher vorgesehen, wobei dann jeder Zuordnungsspeicher wenigstens eine Validierungsspeicherzelle mit einer Validierungsadreßleitung aufweist. Damit wird jeder Redundanz-Selektionsleitung wie beispielsweise einer Redundanzwortleitung genau ein Zuordnungsspeicher mit einem ganzen Satz von Zuordnungsspeicherzellen sowie mit einer Validierungsspeicherzelle beigeordnet, wobei alle Zuordnungsspeicher parallel auf den Adreßbus geschaltet werden. Somit empfängt jeder Zuoränungsspeicher die momentan auf dem Adreßbus anliegende Adresse, wobei bei geeigneter Programmierung der Zuordnungsspeicherzellen einzelne Zuordnungsspeicher zu bestimmten, auf dem Adreßbus anliegenden Adressen zuordenbar sind. Durch die geeignete Programmierung der Validierungsspeicherzelle kann dann sichergestellt werden, daß nur der gewünschte Zuordnungsspeicher auf die momentan am Adreßbus anliegende Adressen anspricht.

Die vorstehend erläuterten Aasbildungen des erfindungsgemäßen Datenspeichers erweisen sich vor allen Dingen beim Normalbetrieb des Datenspeichers als vorteilhaft, bei dem auf den Datenspeicher zugegriffen wird. Insbesondere zur einfachen Programmierung der Zuordnungsspeicher des erfindungsgemäßen Datenspeichers weist dieser die folgenden Merkmale auf:
- die Redundanz-Selektionsleitungsauswahlschaltung weist nicht nur einen, sondern mehrere und insbesondere statische Zuordnungsspeicher zur Aufnahme der Zuordnungsinformation auf,
- im Bereich der Zuordnungsspeicherzellen sind Zuordnungsadreßleitungen vorgesehen, wobei durch Anlegen wenigstens eines Zuordnungsadreßsignals an wenigstens eine Zuordnungsadreßleitung wenigstens ein Zuordnungsspeicher selektierbar ist.

Durch die vorstehende Weiterbildung der Erfindung kann einer der mehreren Zuordnungsspeicher beim Programmieren einfach ausgewählt werden.

Dabei ist vorteilhafterweise wenigstens ein zwischen einen Zuordnungsadreßbus und die Zuordnungsadreßleitungen geschalteter Zuordnungsspeicherauswahldecoder vorgesehen, der so ausgebildet sein kann, daß eine oder mehrere Zuordnungsadreßleitungen entsprechend einer am Zuordnungsadreßbus anliegenden Adresse selektierbar sind. Der Zuordnungsspeicherauswahldecoder kann dabei als Schaltwerk ausgebildet sein, das auf einem parallelen Bus ankommende kodierte Zuordnungsspeicheradressen in an einzelnen Zuordnungsspeichern anliegende Signale umwandelt.

Bei dem wie vorstehend ausgebildeten Gegenstand der Erfindung gewährleistet ein einziger Adreßbus den Zugriff auf das Speicherzellenfeld und die Redundanzspeicherzellen, während mit einem Zuordnungsadreßbus diejenigen Zuordnungsspeicherzellen adressiert werden, die zur Zuordnung der Redundanzspeicherzellen zu den Speicherzellen programmiert werden müssen.

Bei einer besonders einfach zu handhabenden Ausgestaltung der Erfindung erfolgt das Programmieren der Zuordnungsspeicher, indem in jedem Zuordnungsspeicher die Adresse einer anderen zu ersetzenden Speicherzelle abgespeichert wird, wobei über den Zuordnungsspeicherauswahldecoder ausgewählt wird, welcher Zuordnungsspeicher die Adressierung für eine bestimmte zu ersetzende Speicherzelle übernimmt. Dabei wird das am Adreßbus anliegende Selektionssignal für die zu ersetzende Speicherzelle gleich als Programmierungssignal für den Zuordnungsspeicher mitverwendet, wobei durch geeignete Verschaltung sichergestellt ist, daß immer nur ein Zuordnungsspeicher zur Zeit mit einer Adresse programmiert wird. In dieser Ausgestaltung ergibt sich der erfindungswesentliche Vorteil, daß bereits die am Adreßbus anliegenden Signale geringer Stärke ausreichen, um den Zuordnungsspeicher mit den Zuordnungsinformationen zu versorgen. Im Stand der Technik war dies nicht möglich, vielmehr wurden zum Programmieren der Redundanz-Selektionsleitungsauswahlschaltung hohe separat erzeugte Programmierspannungen benötigt.

Die Erfindung ist in der Zeichnung anhand eines Ausführungsbeispiels näher veranschaulicht.
- Figur 1: zeigt ein Blockschaltbild eines erfindungsgemäßen Datenspeichers,
- Figur 2: zeigt ein vereinfachtes Blockschaltbild, das die Arbeitsweise einer Zuordnungsspeicherzelle zusammen mit einem Latch in eines erfindungsgemäßen Datenspeicher veranschaulicht,
- Figur 3: zeigt ein Blockschaltbild eines Redundanzadreßdecoders des Datenspeichers aus Figur 1,
- Figur 4: zeigt ein Blockschaltbild eines Zuordnungsspeicherauswahldecoders aus Figur 3,
- Figur 5: zeigt ein Blockschaltbild eines Zuordnungsspeichers des Redundanzadreßdecoders aus Figur 3,
- Figur 6: zeigt ein Schaltbild einer Zuordnungsspeicherzelle des Zuordnungsspeichers aus Figur 5,
- Figur 7: zeigt eine Sense-Schaltung der in Figur 6 gezeigten Zuordnungsspeicherzelle in näherem Detail,
- Figur 8: zeigt eine ais Stacked-Gate-Zelle ausgestaltete Zuordnungsspeicherzelle, und
- Figur 9: zeigt eine als Split-Gate-Zelle ausgestaltete Zuordnungsspaicherzelle.

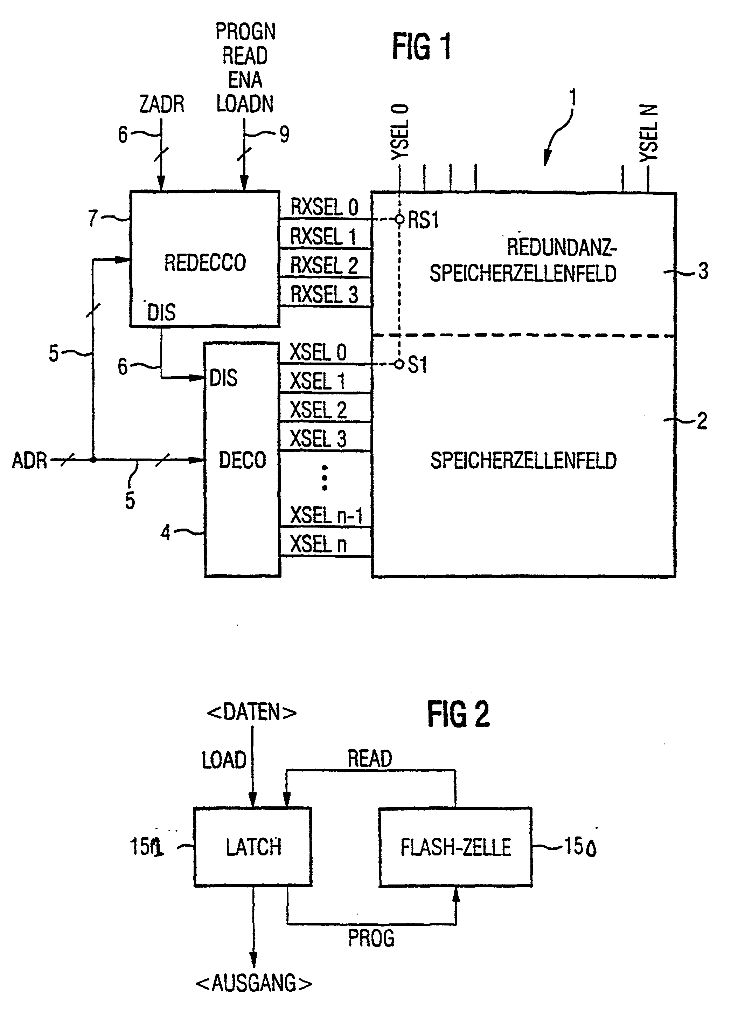

Figur 1 zeigt einen erfindungsgemäßen Datenspeicher 1, der auf einem in dieser Ansicht nicht gezeigten Halbleitersubstrat erzeugt ist.

Der Datenspeicher 1 hat ein Speicherzellenfeld 2, das beispielsweise ein DRAM, ein SRAM, ein EEPROM, ein Flash oder ein FRAM sein kann. Das Speicherzellenfeld 2 weist senkrecht zueinander verlaufende Wortleitungen XSEL0 bis XSELn sowie Bitleitungen YSEL0 bis YSBLn auf. Über die Wort- und Bitleitungen können durch Anlegen geeigneter Selektionssignale einzelne Speicherzellen im Speicherzellenfeld 2 ausgewählt werden. In Figur 1 ist dabei nur eine einzige Speicherzelle S1 dargestellt, die durch Selektieren der Wortleitung XSEL0 und der Bitleitung YSEL0 ausgewählt wird. In dieser Ansicht sind zum Speicherzellenfeld zugehörige Ansteuerschaltungen wie beispielsweise Pegelwandler nicht gezeigt.

Der Datenspeicher 1 weist weiterhin ein Redundanzspeicherzellenfeld 3 auf, das Redundanzwortleitungen RXSEL0 bis RXSEL3 aufweist. Im übrigen verwendet das Redundanzspeicherzellenfeld 3 die Bitleitungen YSEL0 bis YSELN des Speicherzellenfelds 2 mit. Über die Redundanzwortleitungen RXSEL0 bis RXSEL3 und die Bitleitungen YSEL1 bis YSELn können Redundanz-speicherzellen des Redundanzspeicherzellenfelds 3 ausgewählt werden. In Figur 1 ist nur eine Redundanzspeicherzelle RS1 dargestellt, die durch Anlegen geeigneter Signale an die Wortleitung RXSEL0 und an die Bitleitung YSEL0 ausgewählt werden kann. Der Datenspeicher 1 hat weiterhin einen Adreßdecoder 4 für die Wortleitungen XSEL0 bis XSELn des Speicherzellenfelds 2. Der Adreßdecoder 4 empfängt Adreßdaten von einem parallelen Adreßbus 5, der mehrere parallele Adreßleitungen aufweist, was in der Zeichnung durch einen auf dem Adreßbus 5 angebrachten Schrägstrich verdeutlicht ist. Der Adreßdecoder 4 wandelt die am Adreßbus 5 anliegenden Adreßen in Ansteuerungssignale für die Wortleitungen bis XSELn um. Der Adreßdecoder 4 ist hierzu auf übliche Weise aufgebaut und wird hier nicht eigens beschrieben. Weiterhin weist der Adreßdecoder 4 einen Deaktivierungseingang 6 auf. Wird an den Deaktivierungseingang 6 ein logisches "1"-signal angelegt, werden alle Signale XSEL0 bis XSELn auf logisch "0" gesetzt.

Der Datenspeicher 1 hat schließlich noch einen Redundanzadreßdecoder 7, der in Abhängigkeit von seiner internen Programmierung und den vom Adreßbus 5 ankommenden Adreßdaten die Redundanzwortleitungen RXSEL0 bis RXSEL3 ansteuert. Der Redundanzadreßdecoder 7 steht mit dem Deaktivierungseingang 6 des Adreßdecoders 4 in Verbindung, und zwar derart, daß der Adreßdecoder durch den Redundanzadreßdecoder 7 deaktivierbar ist. Der Redundanzadreßdecoder 7 weist für seine Programmierung und seinen Betrieb einen Zuordnungsadreßbus 8 sowie verschiedene ProgrammierungsSteuerungssignale auf, über die ProgrammierungsSteuerungsignale PROGN, READ, ENA und LOADN in den Redundanzadreßdecoder 7 eingegeben werden können.

In Figur 1 ist die aus Redundanzspeicherzellenfeld 3 und Redundanzadreßdecoder 7 bestehende Redundanzschaltung exemplarisch für die Wortleitungen XSEL0 bis XSELn vorgesehen. Ebenso kann eine Redundanzschaltung für die Bitleitungen YSEL0 bis YSELn vorgesehen sein. Wegen der vereinfachten Darstellung ist eine derartige Redundanzschaltung für die Bitleitungen in dieser Ansicht nicht gezeigt.

Figur 2 zeigt das Grundprinzip des Betriebs einer erfindungsgemäßen Zuordnungsspeicherzelle in einem Datenspeicher, die hier als Flash-Zelle 150 ausgebildet ist, zusammen mit einem Zwischenspeicher bzw. Latch 151. Mit einem Signal LOAD werden Selektionsdaten (d.h. Daten, die angeben, daß eine Zuordnungsspeicherzelle bestimmten Zustand "0" oder "1" aufweist) von dem Eingangsbus <Daten> in den Latch 151 geladen. Der Ausgang des Latch 151 ist Teil der Steuerung Redundanzdecoders, wobei der Redundanzdecoder entsprechend der Anzahl der Redundanz-Selektionsleitungen und entsprechend der Anzahl der Leitungen eines Datenbus zum Zugriff auf den Datenspeicher eine Anzahl von "Register" aus Flash-Zelle 150 und Latch 151 aufweist. Die Ausgänge aller Register zusammen stellen den aktuellen Stand der Programmierung des Redundanzdecoders dar. Mit einem Signal PROG wird die Information des Latch nichtflüchtig in die Flash-Zelle programmiert. Mit dem Signal READ wird diese nichtflüchtige Information wieder in das Latch übertragen, beispielsweise, wenn der Datenspeicher zur Inbetriebnahme erstmals mit Energie versorgt wird.

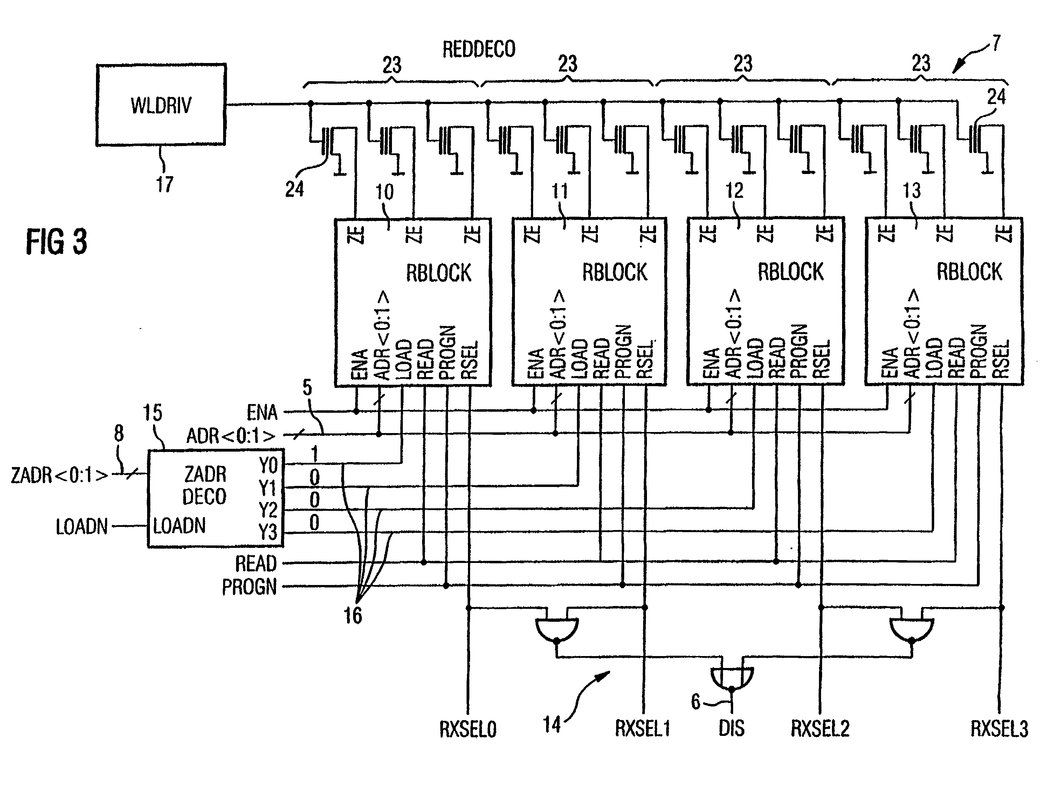

Figur 3 zeigt den Redundanzadreßdecoder 7 aus Figur 1 in näherem Detail. Zentrale Bestandteile des Betriebsbereiches des Redundanzadreßdecoders 7 sind vier Zuordnungssgeicher 10, 11, 12 und 13, die ausgangsseitig jeweils mit einer der Redundanzwortleitungen RXSEL0 bis RXSEL3 in Verbindung stehen. Eingangsseitig stehen die Zuordnungsspeicher 10, 11, 12 und 13 mit dem Adreßbus 5 in Verbindung. Zusätzlich ist jeder der Zuordnungsspeicher 10, 11, 12 und 13 mit einer Aktivierungsleitung verbunden, die ein Signal ENA liefert.

Zur Generierung eines Deaktivierungssignals DIS für den Deaktivierungseingang 6 des Adreßdecoders 4 ist ein Deaktivierungsschaltwerk 14 vorgesehen. Das Deaktivierungsschaltwerk 14 weist zwei NAND-Gatter mit jeweils zwei Eingängen auf, wobei ein HAND-Gatter eingangsseitig mit den Redundanzwortleitungen RXSEL0 und RXSEL1 verbunden ist, während das andere NAND-Gatter eingangsseitig mit den Redundanzwortleitungen RXSEL2 und RXSEL3 verbunden ist. Die Ausgänge der NAND-Gatter werden zwei Eingängen eines NOR-Gatters zugeführt, das das Signal DIS generiert.

Der Adreßbus 5 bildet zusammen mit den Zuordnungsspeichern 10, 11, 12 und 13 sowie mit dem Deaktivierungsschaltwerk 14 den im Normalbetrieb des Datenspeichers 1 aktiven Betriebsbereich des Redundanzadreßdecoders 7. Es ist klar, daß mit steigender Anzahl von Redundanzwortleitungen RXSEL eine steigende Anzahl von Zuordnungsspeichern im Redundanzadreßdecoder 7 vorgesehen werden müssen. Im Ausführungsbeispiel der Erfindung sind jedoch nur vier Redundanzwortleitungen vorgesehen.

Der Redundanzadreßdecoder 7 hat auch einen Programmierungsbereich, der ausschließlich im Programmierungsmodus des Datenspeichers 1 aktiv ist. Dazu weist der Datenspeicher 1 einen Zuordnungsadreßdecoder 15 auf, der eingangsseitig mit dem Zuordnungsadreßbus 8 sowie mit der Steuerungsleitung LOADN verbunden ist. Auf die Eingabe eines geeigneten Zuordnungsadreßsignals auf dem Zuordnungsadreßbus 8 und eines Signals LOADN wird einer der vier Zuordnungsspeicher 10, 11, 12 und 13 für den Programmierbetrieb aktiviert. Hierzu weist der Redundanzadreßdecoder 15 vier Ausgangsleitungen 16 auf, die mit Y0, Y1, Y2 und Y3 bezeichnet sind und die zu Aktivierungseingängen LOAD der Zuordnungsspeicher 10, 11, 12 und 13 zugeführt werden. Weiterhin werden den Zuordnungsspeichern 10, 11, 12, und 13 die externen Programmierungs- Steuerungssignale PROGN und ENA zugeführt

Die Zuordnungsspeicher 10, 11, 12 und 13 weisen weiterhin je drei Eingänge ZE auf, die über je eine Ansteuergruppe 23 aus drei Flash-Zellen 24 durch eine betätigbare Treiberschaltung 17 (WLDRIV) mit einer Programmierspannung versorgt werden, wobei die insbesondere deren Polarität von dem gewünschten Betriebsmodus des Redundanzdecoders 7 abhängt. Die von der Treiberschaltung 17 an die Eingänge ZE (Control Gates der als Zuordnungsspeicherzellen verwendeten Flash-Zellen) ergeben sich wie folgt:

| Betriebsbedingungen | Programmieren | Löschen | Ruhe | Lesen |
|---|---|---|---|---|
| V_{CG} | -12V (0V im deselektierten Zustand) | 15V | 0V | 2,5V |

Die genaue Funktionsweise der Treiberschaltung 17 ist hier nicht gezeigt.

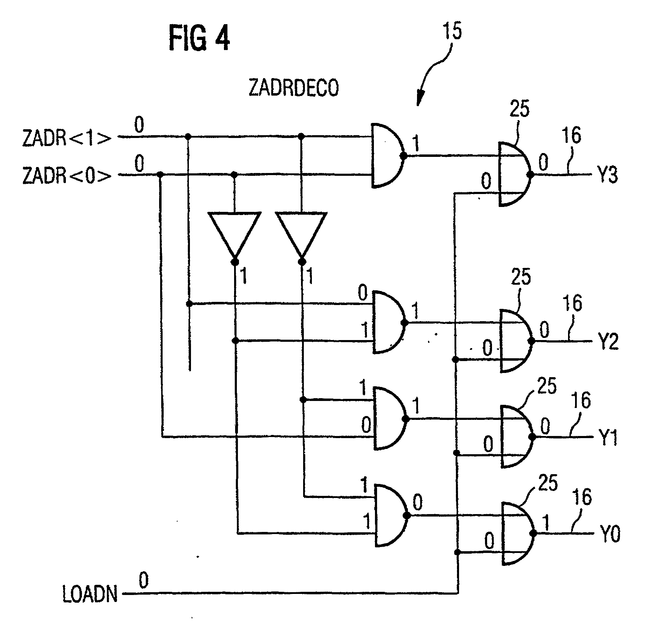

Figur 4 zeigt den Zuordnungsadreßdecoder 15 aus Figur 3 in näherem Detail. Wie man sieht, weist der Zuordnungsadreßdecoder 15 vier NAND-Gatter mit jeweils zwei Eingängen auf, die mit zwei Invertern wie in Figur 4 gezeigt zu einem Zuordnungsadreßdecoder-Schaltwerk 18 verschaltet sind. Wie man in dieser Ansicht besonders gut sieht, hat der Zuordnungsadreßbus 8 nur zwei Zuordnungsadreßleitungen ZADR0 und ZADR1. Aus den beiden jeweils binär codierten Zuordnungsadreßleitungen des Zuordnungsadreßbus 8 werden die Signale für die vier Ausgangsleitungen 16 generiert, und zwar indem je ein Ausgang eines NAND-Gatters zusammen mit dem externen Programmiersignal LOADN je einem NOR-Gatter 20 zugeführt wird. Je ein Ausgang eines NOR-Gatters 20 generiert eines der Signale für die Ausgangsleitungen Y0, Y1, Y2 und Y3. Dadurch wird wie in Figur 4 gezeigt ein Zuordnungsadreßsignal "00" auf dem Zuordnungsadreßbus 8 so umgewandelt, daß an der Ausgangsleitung Y0 der logische Pegel "1" anliegt, während bei den übrigen Ausgangsleitungen Y1, Y2 und Y3 der logische Pegel "0" anliegt.

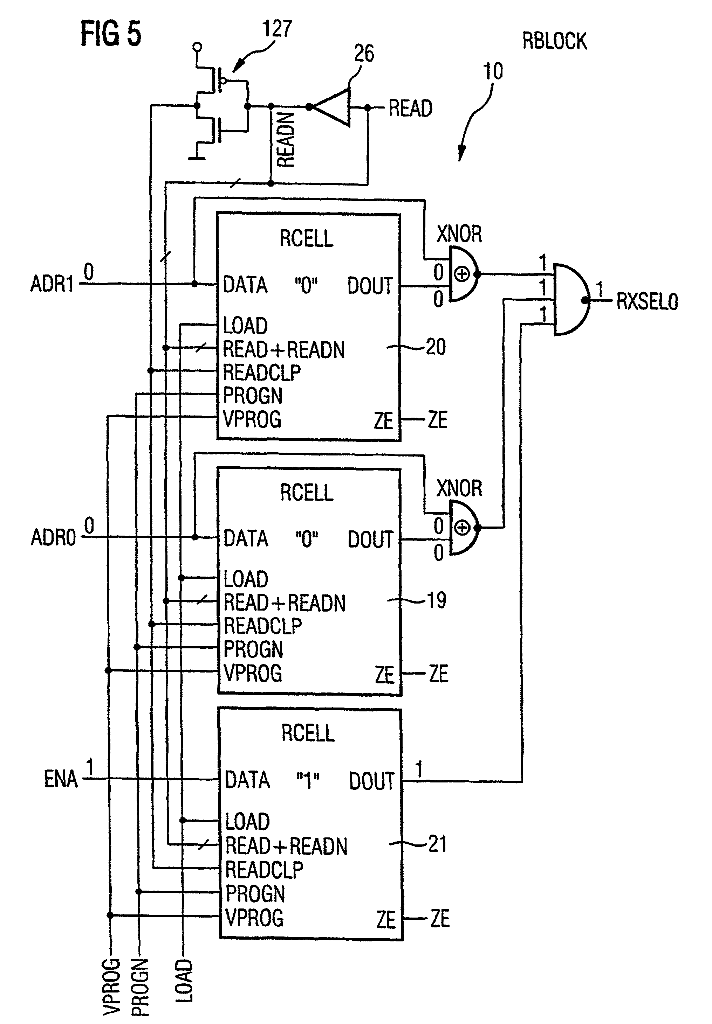

Figur 5 zeigt den Zuordnungsspeicher 10 aus Figur 3 in näherem Detail. Wie man in dieser Ansicht besonders gut sieht, umfaßt der Adreßbus 5, der dem Zuordnungsspeicher 10 zugeführt wird, hier nur zwei Adreßleitungen ADR0 und ADR1. Entsprechend der Anzahl der Einzelleitungen des Adreßbus 5 sind zwei Zuordnungsspeicherzellen 19 und 20 im Zuordnungsspeicher 10 vorgesehen. Dabei steht die Zuordnungsspeicherzelle 19 eingangsseitig (Anschluß DATA) mit der Leitung ADR0 des Adreßbus 5 in Verbindung, während die Zuordnungsspeicherzelle 20 eingangsseitig (Anschluß DATA) mit der Leitung ADR1 des Adreßbus 5 in Verbindung steht. Mit steigender Zahl von Einzelleitungen des Adreßbus 5 sind steigende Anzahlen von Zuordnungsspeicherzellen notwendig, um eine korrekte Adreßdecodierung zu gewährleisten.

Weiterhin ist im Zuordnungsspeicher 10 eine Validierungsspeicherzelle 21 vorgesehen, die eingangsseitig (Anschluß DATA) mit der bereits in Figur 3 gezeigten Programmierungsleitung ENA in Verbindung steht.

Die beiden Ausgänge DOUT der Zuordnungsspeicherzelle 19 und der Zuordnungsspeicherzelle 20 sind je einem XNOR-Gatter mit zwei Eingängen zugeführt, wobei jeweils der andere Eingang des XNOR-Gatters mit dem jeweiligen Eingangsanschluß DATA der zuordnungsspeicherzelle verbunden ist. Die Ausgänge der beiden XNOR-Gatter sowie der Ausgang DOUT der Validierungsspeicherzelle 21 sind einem AND-Gatter mit drei Eingängen zugeführt. Der Ausgang des AND-Gatters führt zu der Redundanzwortleitung RXSEL0, wie am besten in Figur 3 zu sehen ist.

Die Zuordnungsspeicherzellen 19 und 20 sowie die Validierungsspeicherzelle 21 sind an sich jeweils identisch aufgebaut. Sie weisen eine erste Gruppe von Programmierungs- und Steuereingangsleitungen VPROG, PROGN und LOAD auf, die an entsprechende Programmierungs- und Steuerungsleitungen zum Zuordnungsspeicher 10 angeschlossen sind. Weiterhin sind an den Zuordnungsspeicherzellen 19 und 20 sowie an der Validierungsspeicherzelle 21 eine zweite Gruppe von Programmierungseingängen READ, READN und READCLP vorgesehen, wobei die entsprechenden Programmierungssignale READN und READCLP aus dem externen Signal READ generiert werden. Hierzu wird das Signal READ zunächst über einen Inverter 26 zum Signal READN invertiert. Aus dem Signal READN wird dann über eine in Figur 5 gezeigte Treiberschaltung 127 das Analogsignal READCLP generiert. Wenn READ gleich der Spannung Vdd ist (z.B gleich 5V), dann gilt READCLP=VCLP (für z.B. VCLP=1,2V).

Hinsichtlich des Aufbaus des Zuordnungsspeichers 10 ist noch wesentlich, daß die Zuordnungsspeicherzellen 19 und 20 sowie die Validierungsspeicherzelle 21 bezüglich der Programmierungseingänge VPROG, PROGN, LOAD, READ, READN und READCLP parallel geschaltet sind.

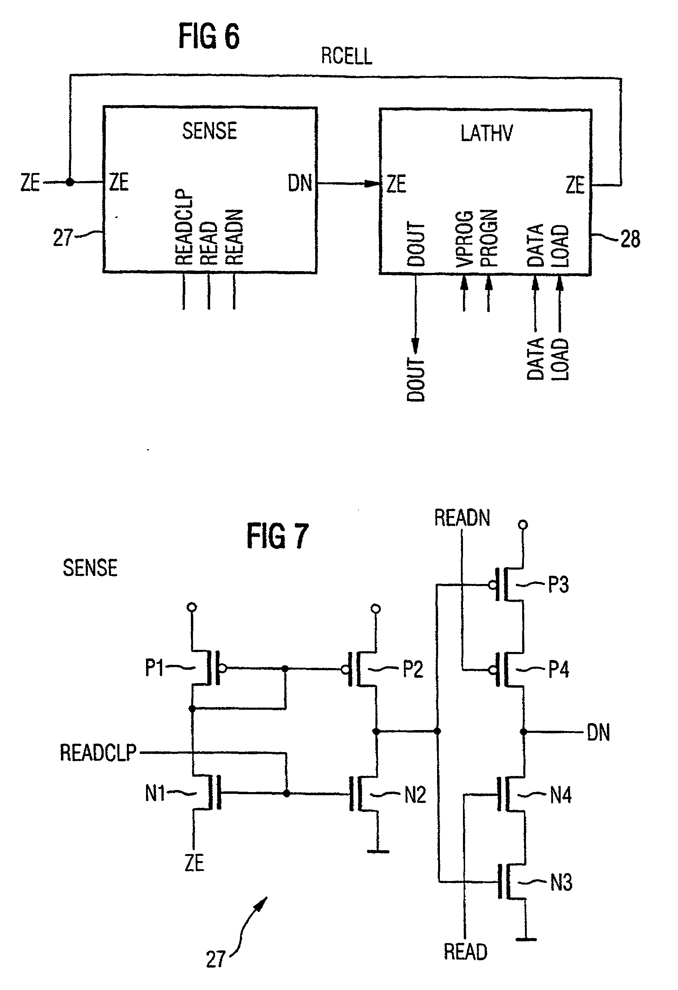

Figur 6 zeigt die Zuordnungsspeicherzelle 19 aus Figur 5 in näherem Detail. Die Zuordnungsspeicherzelle 19 gliedert sich in eine Leseschaltung 27 (SENSE) und in eine Hochvolt-Latchschaltung 28 (LATHV). Bei LOAD gleich logisch "1" wird der Wert von DATA in die Latchschaltung 28 übertragen und erscheint an DOUT. Mit LOAD gleich logisch "0" wird der Wert gehalten. LATHV besitzt einen zweiten Eingang DN, wobei der Wert an diesem Eingang invertiert in die Latchschaltung 28 übertragen wird. Da dieser Eingang kein eigenes Selektionssignal hat, muß der Eingang im Ruhezustand hochohmig beschaltet sein.

Figur 7 zeigt die Leseschaltung 27 aus Figur 6 in näherem Detail. Entsprechend den Anforderungen der Latchschaltung 28 hat die Leseschaltung 27 einen Tristate-Ausgang DN. Im Fall READ gleich logisch "0" ist dieser Ausgang hochohmig. Im Fall READ gleich logisch "1" wird der detektierte Wert der Flash-Zelle (niedriges Vt gleich logisch "1" gleich 0V auf der Leitung ZE) in die Latchschaltung 28 übertragen. im Programmiermodus (PROGN=0) wird je nach gespeicherter Information die Programmierspannung an VPROG (z.B. 5V) oder 0V auf die Ausgänge ZE durchgeschaltet. Das Control Gate der Zellen wird beim Programmieren auf z.B. -12V gehalten. Vor jedem Programmieren müssen die Flash-Zellen durch Anlegen von z.B. 15V am Control Gate und 0V an ZE gelöscht werden.

Das an ZE anliegende Signal wird über N1 an P1 und P2 gespiegelt und ggf. verstärkt. Der Strom-Schaltunkt der Schaltung wird dabei durch Dimensionierung von N1, P1, P2 und N2 eingestellt. Der Ausgang DN kann einen hochohmigen Zustand annehmen, indem READ=0V und READN=Vdd gesetzt werden.

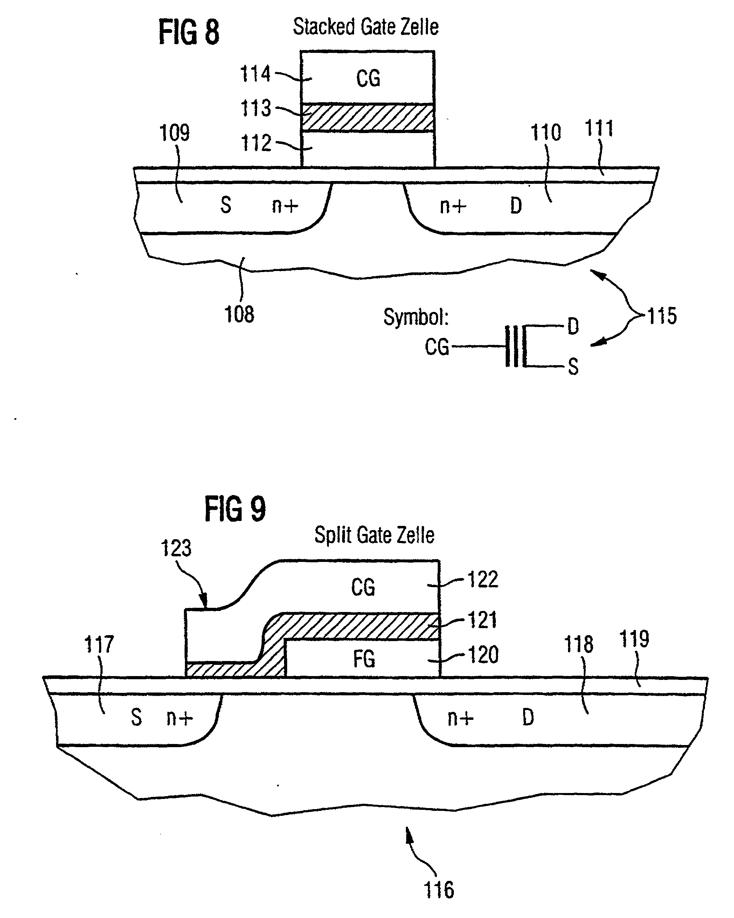

Figur 8 zeigt eine als Stacked-Gate-Zelle 115 ausgestaltete Speicherzelle eines erfindungsgemäßen Zuordnungsspeichers. In ein Substrat 108 ist durch Dotierung eine Source 109 sowie eine Drain 110 eingebracht. Auf dem Substrat befindet sich eine Tunneloxid-Schicht 111, auf der eine Floating-Gate-Schicht 112 aufgebracht ist. Auf der Floating-Gate-Schicht 112 ist ein Inter-Poly-Dielectricum 113 aufgebracht. Schließlich ist auf dem Inter-Poly-Dielectricum 113 noch eine Control-Gate-Schicht 114 aufgebracht, die ebenfalls ausschließlich mit dem Inter-Poly-Dielectricum in Verbindung steht. Unterhalb der Darstellung in Figur 8 ist die symbolhafte Bezeichnung der Stacked-Gate-Zelle 115 angegeben.

Figur 9 zeigt eine als Split-Gate-Zelle 116 ausgestaltete Speicherzelle eines erfindungsgemäßen Datenspeichers. In ein Halbleitersubstrat ist eine Source 117 und eine Drain 118 durch Dotieren eingebracht. Auf dem Substrat befindet sich eine Tunneloxid-Schicht 119 sowie ein Floating-Gate-Bereich 120. Auf den Floating-Gate-Bereich 120 ist ein Inter-Poly-Dielectricum 121 aufgebracht, und zwar derart, daß sich ein Bereich des Inter-Poly-Dielectricums 121 von der Oberseite des Floating-Gates 120 herunter auf die Tunneloxid-Schicht 119 erstreckt. Auf dem Inter-Poly-Dielectricum 121 befindet sich das Control-Gate 122, wobei der sich von dem Bereich oberhalb des Inter-Poly-Dielectricums 121 in den Bereich der Tunneloxid-Schicht 119 erstreckende Bereich als Serien-Gate 123 ausgebildet ist.

Im Betrieb verhält sich der erfindungsgemäße Datenspeicher 1, wie nachfolgend anhand der Figuren 1 bis 7 beschrieben ist. Dazu wird angenommen, daß nach der Herstellung des Datenspeichers 1 in einem Testvorgang herausgefunden wurde, daß die Speicherzelle S1 defekt ist und daß die als ordnungsgemäß arbeitend herausgefundene Redundanzspeicherzelle RS1 deren Funktion übernehmen soll.

Beim Programmieren des Datenspeichers 1 derart, daß die Funktion der Speicherzelle S1 durch die Redundanzspeicherzelle RS1 übernommen wird, wird dazu am Adreßbus 1 eine Wortleitungsadresse "00" angelegt, die die Wortleitung XSEL0 anwählt. Dazu wird auf den beiden Selektionsleitungen ADR0 und ADR1 des Adreßbus 5 (vgl. Figur 5) der Wert logisch "00" erzeugt.

Da der Zuordnungsspeicher 10 die Zuordnung der Redundanzspeicherzelle RS1 vornimmt, muß dieser zunächst für seine Programmierung 10 ausgewählt werden. Dies geschieht dadurch, daß am Zuordnungsadreßbus 8 eine Zuordnungsadresse "00" angelegt wird, die über die Ausgangsleitung Y0 (vgl. Figur 3 und Figur 4) den Zuordnungsspeicher 10 auswählt. Wie in Figur 4 gezeigt ist, geschieht dies dadurch, daß auf Zuordnungsadreßleitungen ZADR0 und ZADR1 die logische Adresse "00" angelegt wird. Daraufhin erscheint an der Ausgangsleitung Y0 ein Zustand logisch "1", während die übrigen Ausgangsleitungen Y1, Y2 und Y3 jeweils auf dem logischen Pegel "0" liegen. Durch Anlegen von LOADN="0" werden die RAM-Zellen in der Zuordnungsspeicherzelle 19 mit den an den Leitungen ADR0 und ADR1 anliegenden Werten belegt.

Vor dem Programmieren des nichtflüchtigen Teils werden die Flash-Zellen im Zuordnungsspeicher 10 durch Anlegen von 15V am Control-Gate und von 0V an ZE gelöscht (vgl. Figuren 6 und 7). Außerdem müssen noch die Leitungen PROGN (Figur 5) auf "0" gesetzt werden und eine entsprechende Programmierspannung an VPROG angelegt werden (vgl. Beschreibung zu den Figuren 6 und 7). Auf diese Weise werden in den nichtflüchtigen Teil der Zuordnungsspeicherzelle 19 und der Zuordnungsspeicherzelle 20 die Werte logisch "0" geschrieben, und zwar entsprechend den auf den Selektionsleitungen ADR0 und ADR1 anliegenden logischen Werten.

Außerdem wird die Eingangsleitung ENA (vgl. Figur 3 und Figur 5) auf den Zustand logisch "1" gebracht. In der Validierungsspeicherzelle 21 befindet sich nach dem Programmieren entsprechend dem auf der Eingangsleitung ENA anliegenden Wert logisch "1" ebenfalls der Wert logisch "1". Dadurch ist nach dem Programmieren die Redundanzspeicherzelle RS1 der Speicherzelle S1 zugeordnet.Im Betrieb verhält sich der wie vorstehend programmierte Datenspeicher 1 wie nachfolgend beschrieben. Dazu wird angenommen, daß im Betrieb des Datenspeichers 1 versucht werden soll, auf die Speicherzelle S1 zuzugreifen. Dazu wird auf die Selektionsleitungen ADR0 und ADE1 des Adreßbusses 5 das Adreßdatum logisch "00" angelegt (vgl. Figur 5). Die Programmierungsleitungen ENA, READ, READN, VPROG und PROGN haben bei dem Betrieb des Datenspeichers 1 nach dessen Initialisierung keinerlei Funktion, sie werden deaktiviert gehalten.

An den beiden Eingängen der in Figur 5 gezeigten XN4R-Gatter liegt dann jeweils der Wert logisch "0" an, und zwar einmal aufgrund des von den Selektionsleitungen ADR0 und ADR1 gelieferten Wertes logisch "0" und aufgrund der von den Zuordnungsspeicherzelle 19 und 20 gelieferten und während des Programmierens gespeicherten Wertes logisch "0". Die Ausgänge der XNOR-Gatter in Figur 5 erzeugen daraufhin den Wert logisch "1", der dem AND-Gatter in Figur 5 zugeführt wird. In der Validierungsspeicherzelle 21 befindet sich aufgrund der Programmierung der Wert logisch "1", der ebenfalls dem AND-Gatter mit drei Eingängen in Figur 5 zugeführt wird. Somit geht der Ausgang des AND-Gatters mit drei Eingängen in Figur 5 auf logisch "1" über, was die Redundanzwortleitung RXSEL0 (vgl. Figur 3) auswählt. Auf diese Weise wird die zur Redundanzspeicherzelle RS1 zugehörige Wortleitung RXSEL0 ausgewählt, wenn am Adreßbus 5 die zur Speicherzelle S1 weisende Adresse anliegt. Da die Ausgänge RSEL der Zuordnungsspeicher 11, 12 und 13 (vgl. Figur 3) sich auf dem Zustand 0 befinden, während der Ausgang RSEL des Zuordnungsspeichers 10 den Wert logisch "1" hat, nimmt der Ausgang DIS des Deaktivierungsschaltwerks 14 in Figur 3 den Wert logisch "1" an. Dadurch wird der Adreßdecoder 4 (vgl. Figur 1) deaktiviert, so daß Wechselwirkungen zwischen dem Ausgang der Speicherzelle S1 und dem Ausgang der Redundanzspeicherzelle RS1 verhindert werden.

## Patentansprüche

1. Datenspeicher (1), der die folgenden Merkmale aufweist:
- wenigstens ein Speicherzellenfeld (2), das Speicherzellen (S1) aufweist, wobei die Speicherzellen (S1) durch Anlegen wenigstens eines Selektionssignals an im Bereich der Speicherzellen (S1) vorgesehene Selektionsleitungen (XSEL1, ..., XSELn) selektierbar sind, wobei die Selektionsleitungen Wortleitungen und/oder Bitleitungen umfassen,
- eine Redundanzschaltung (3, 7), die wenigstens eine Redundanzspeicherzelle (RS1) aufweist, wobei die Redundanzspeicherzellen (RS1) durch Anlegen wenigstens eines Redundanz-Selektionssignals an im Bereich der Redundanzspeicherzellen (RS1) vorgesehene Redundanz-Selektionsleitungen (RXSEL1, ..., RXSEL4) selektierbar sind, wobei die Redundanz-Selektionsleitungen Redundanzwortleitungen (RXSEL1, ..., RXSEL4) und/oder Redundanzbitleitungen umfassen,
- eine Redundanz-Selektionsleitungsauswahlschaltung, die mindestens einen Zuordnungsspeicher aufweist, in dem eine Zuordnungsinformation abspeicherbar ist, wobei die Redundanz -Selektionsleitungsauswahlschaltung so ausgebildet ist, daß aufgrund der Zuordnungsinformation wenigstens eine Redundanz-Selektionsleitung (RXSEL1) zu wenigstens einer Selektionsleitung (XSEL1) zuordenbar ist,
- der Zuordnungsspeicher weist zur Aufnahme der Zuordnungsinformation eine Zuordnungsspeicherzelle mit einem Zwischenspeicher auf,
- der Zuordnungsspeicher ist so ausgebildet, daß in einem Betriebsmodus des Datenspeichers (1) die Zuordnungsinformation von der Zuordnungsspeicherzelle in den Zwischenspeicher übertragbar ist,
gekennzeichnet durch das folgende Merkmal:
- der Zuordnungsspeicher ist so ausgebildet, daß in einem Programmiermodus des Datenspeichers (1) die Zuordnungsinformation vom Zwischenspeicher in die Zuordnungsspeicherzelle übertragbar ist.

2. Datenspeicher nach Anspruch 1, dadurch gekennzeichnet, daß die Zuordnungsspeicherzellen so ausgebildet sind, daß sie mit einer positiven Spannung löschbar und mit einer negativen Spannung programmierbar sind.

3. Datenspeicher nach Anspruch 2, dadurch gekennzeichnet, daß die Zuordnungsspeicherzellen als Flash-Speicherzellen ausgebildet sind, die mit einer positiven Spannung am Control Gate löschbar und mit einer negativen Spannung am Control Gate programmierbar sind.

4. Datenspeicher nach einem der vorhergehenden Ansprüche, dadurch gekennzeichnet, daß die Zuordnungsspeicherzellen so ausgebildet sind, daß sie jeweils unter Anwendung von Fowler-Nordheim-Tunnelströmen löschbar und programmierbar sind.

5. Datenspeicher nach einem der vorhergehenden Ansprüche, dadurch gekennzeichnet, daß die Zuordnungsspeicherzellen jeweils als Stacked-Gate-Zelle ausgebildet sind.

6. Datenspeicher nach einem der vorhergehenden Ansprüche, dadurch gekennzeichnet, daß die Zuordnungsspeicherzellen jeweils als Split-Gate-Zelle ausgebildet sind.

7. Datenspeicher nach einem der vorhergehenden Ansprüche, dadurch gekennzeichnet, daß er die folgenden Merkmale aufweist:
- wenigstens einen Adreßdecoder (4), der zwischen einen Adreßbus (5) und die Selektionsleitungen (XSEL 1, ..., XSEL n) geschaltet ist und der so ausgebildet ist, daß eine oder mehrere Selektionsleitungen (XSEL 1, ..., XSEL n) entsprechend einer am Adreßbus (5) anliegenden Adresse selektierbar sind,
- wenigstens einen Redundanzadreßdecoder (7), der zwischen den Adreßbus (5) und die Redundanz-Selektionsleitungen (RXSEL 1, ..., RXSEL 3) geschaltet ist und der so ausgebildet ist, daß eine oder mehrere Redundanz-Selektionsleitungen (RXSEL 1, ..., RXSEL 3) entsprechend einer am Adreßbus (5) anliegenden Adresse selektierbar sind, und
- die Redundanz-Selektionsleitungsauswahlschaltung ist im Bereich des Redundanzadreßdecoders (7) angeordnet.

8. Datenspeicher nach Anspruch 7, dadurch gekennzeichnet, daß der Adreßdecoder (4) so ausgebildet ist, daß er durch den Redundanzadreßdecoder (7) deaktivierbar ist.

9. Datenspeicher nach Anspruch 7 oder Anspruch 8, dadurch gekennzeichnet, daß er die folgenden Merkmale aufweist:
- der Adreßbus (5) ist als paralleler Bus mit einer Anzahl von Adreßbusleitungen (ADR0, ADR1) ausgebildet,
- der Zuordnungsspeicher (10, 11, 12, 13) weist Zuordnungsspeicherzellen (19, 20) auf, wobei die Anzahl der Zuordnungsspeicherzellen (19, 20) gleich der Anzahl der Adreßbusleitungen (ADR0, ADR1) ist.

10. Datenspeicher nach Anspruch 9, dadurch gekennzeichnet, daß der Zuordnungsspeicher (10, 11, 12, 13) wenigstens eine Validierungsspeicherzelle (21) mit einer Validierungsadreßleitung (ENA) aufweist.

11. Datenspeicher nach einem der vorhergehenden Ansprüche, dadurch gekennzeichnet, daß er die folgenden Merkmale aufweist:
- die Redundanz-Selektionsleitungsauswahlschaltung weist mehrere Zuordnungsspeicher (10, 11, 12, 13) zur Aufnahme der Zuordnungsinformation auf, 1
- im Bereich der Zuordnungsspeicherzellen sind Zuordnungsadreßleitungen (R SEL) vorgesehen, wobei durch Anlegen wenigstens eines Zuordnungssignals an wenigstens eine Zuordnungsadreßleitung (R SEL) wenigstens ein Zuordnungsspeicher (10, 11, 12, 13) selektierbar ist.

12. Datenspeicher nach Anspruch 6, dadurch gekennzeichnet, daß wenigstens ein zwischen einen Zuordnungsadreßbus (8) und die Zuordnungsadreßleitungen (R SEL) geschalteter Zuordnungsspeicherauswahldecoder (15) vorgesehen ist, der so ausgebildet ist, daß eine oder mehrere Zuordnungsadreßleitungen (R SEL) entsprechend einer am Zuordnungsadreßbus (8) anliegenden Adresse selektierbar sind.

## Claims

1. Data memory (1) which has the following features
- at least one memory location field (2) which has memory locations (S1), it being possible to select the memory locations (S1) by applying at least one selection signal to selection lines (XSEL1, ..., XSELn) provided in the region of the memory locations (S1), the selection lines comprising word lines and/or bit lines,
- a redundancy circuit (3, 7) which has at least one redundancy memory location (RS1), it being possible to select the redundancy memory locations (RS1) by applying at least one redundancy selection signal to redundancy selection lines (RXSEL1, ..., RXSEL4) provided in the region of the redundancy memory locations (RS1), the redundancy selection lines comprising redundancy word lines (RXSEL1, ..., RXSEL4) and/or redundancy bit lines,
- a redundancy selection line selector module which has at least one assignment memory in which an item of assignment information can be stored, the redundancy selection line selector module being designed such that it is possible on the basis of the assignment information for at least one redundancy selection line (RXSEL1) to be assigned to at least one selection line (XSEL1),
- the assignment memory has an assignment memory location with a buffer for the purpose of holding the assignment information,
- the assignment memory is designed such that in one operating mode of the data memory (1) the assignment information can be transferred from the assignment memory location into the buffer,
characterized by the following feature:
- the assignment memory is designed such that it is possible in one programming mode of the data memory (1) for the assignment information to be transferred from the buffer into the assignment memory location.

2. Data memory according to Claim 1, characterized in that the assignment memory locations are designed such that they can be erased by a positive voltage and can be programmed by a negative voltage.

3. Data memory according to Claim 2, characterized in that the assignment memory locations are designed as flash memory locations which can be erased by a positive voltage at the control gate and can be programmed by a negative voltage at the control gate.

4. Data memory according to one of the preceding claims, characterized in that the assignment memory locations are designed such that they can be erased and can be programmed in each case using Fowler-Nordheim tunnel currents.

5. Data memory according to one of the preceding claims, characterized in that the assignment memory locations are designed in each case as a stacked gate location.

6. Data memory according to one of the preceding claims, characterized in that the assignment memory locations are designed in each case as a split gate location.

7. Data memory according to one of the preceding claims, characterized in that it has the following features:
- at least one address decoder (4) which is connected between an address bus (5) and the selection lines (XSEL1, ..., XSEL n) and is designed such that one or more selection lines (XSEL1, ..., XSEL n) can be selected in accordance with an address present on the address bus (5),
- at least one redundancy address decoder (7) which is connected between the address bus (5) and the redundancy selection lines (RXSEL 1, ..., RXSEL 3) and is designed such that one or more redundancy selection lines (RXSEL 1, ..., RXSEL 3) can be selected in accordance with an address present on the address bus (5), and
- the redundancy selection line selector module is arranged in the region of the redundancy address decoder (7).

8. Data memory according to Claim 7, characterized in that the address decoder (4) is designed such that it can be deactivated by the redundancy address decoder (7).

9. Data memory according to Claim 7 or Claim 8, characterized in that it has the following features:
- the address bus (5) is designed as a parallel bus with a number of address bus lines (ADR0, ADR1), and
- the assignment memory (10, 11, 12, 13) has assignment memory locations (19, 20), the number of the assignment memory locations (19, 20) being equal to the number of the address bus lines (ADR0, ADR1).

10. Data memory according to Claim 9, characterized in that the assignment memory (10, 11, 12, 13) has at least one validation memory location (21) with a validation address line (ENA).

11. Data memory according to one of the preceding claims, characterized in that it has the following features:
- the redundancy selection line selector module has a plurality of assignment memories (10, 11, 12, 13) for the purpose of holding the assignment information, and
- assignment address lines (R SEL) are provided in the region of the assignment memory locations, it being possible to select at least one assignment memory (10, 11, 12, 13) by applying at least one assignment signal to at least one assignment address line (R SEL).

12. Data memory according to Claim 6, characterized in that at least one assignment memory selector decoder (15) is provided which is connected between an assignment address bus (8) and the assignment address lines (R SEL) and is designed such that one or more assignment address lines (R SEL) can be selected in accordance with an address present on the assignment address bus (8).

## Revendications

1. Mémoire (1) de données qui comporte les caractéristiques suivantes:
- au moins un champ (2) de cellules de mémoire qui comporte des cellules (S1) de mémoire, les cellules (S1) de mémoire pouvant être sélectionnées par application d'au moins un signal de sélection à des lignes (XSEL1, ..., XSELn) de sélection prévues dans la zone des cellules (S1) de mémoire, les lignes de sélection comprenant des lignes de mots et/ou des lignes de bits,
- un circuit (3, 7) redondant qui comporte au moins une cellule (RS1) de mémoire redondante, les cellules (RS1) de mémoire redondantes pouvant être sélectionnées par application d'au moins un signal de sélection redondant à des lignes (RXSEL1, ..., RXSEL4) de sélection redondantes prévues dans la zone des cellules (RS1) de mémoire redondante, les lignes de sélection redondantes comprenant des lignes (RXSEL1, ..., RXSEL4) de mots redondantes et/ou des lignes de bits redondantes.
- un circuit de sélection de lignes de sélection redondantes qui comporte au moins une mémoire d'association dans laquelle une information d'association peut être mémorisée, le circuit de sélection de lignes de sélection redondantes étant réalisé de telle manière qu'au moins une ligne (RXSEL1) de sélection redondante peut étre associée à au moins une ligne (XSEL1) de sélection sur la base de l'information d'association,
- la mémoire d'association comporte, pour la réception de l'information d'association, une cellule de mémoire d'association comportant une mémoire tampon,
- la mémoire d'association est réalisée de telle manière que, en un mode de fonctionnement de la mémoire (1) de données, l'information d'association peut être transmise de la cellule de mémoire d'association à la mémoire tampon,
caractérisée par la caractéristique suivante:
- la mémoire d'association est réalisée de telle manière que, en un mode de programmation de la mémoire (1) de données, l'information d'association peut être transmise de la mémoire tampon à la cellule de mémoire d'association.

2. Mémoire de données suivant la revendication 1, caractérisée en ce que les cellules de mémoire d'association sont réalisées de telle manière qu'elles peuvent être effacées par une tension positive et qu'elles peuvent être programmées par une tension négative.

3. Mémoire de données suivant la revendication 2, caractérisée en ce que les cellules de mémoire d'association sont réalisées en cellules de mémoire flash qui peuvent être effacées par une tension positive sur la grille de contrôle et qui peuvent être programmées par une tension négative sur la grille de contrôle.

4. Mémoire de données suivant l'une des revendications précédentes, caractérisée en ce que les cellules de mémoire d'association sont réalisées de telle manière peuvent être effacées et programmées respectivement en utilisant des courants de tunnel de Fowler-Nordheim.

5. Mémoire de données suivant l'une des revendications précédentes, caractérisée en ce que les cellules de mémoire d'association sont réalisées chacune en cellule à grille superposée.

6. Mémoire de données suivant l'une des revendications précédentes, caractérisée en ce que les cellules de mémoire d'association sont réalisées chacune en cellule à grille séparée.

7. Mémoire de données suivant l'une des revendications précédentes, caractérisée en ce qu'elle comporte les caractéristiques suivantes:
- au moins un décodeur (4) d'adresse, qui est branché entre un bus (5) d'adresse et les lignes (XSEL1, ..., XSELn) de sélection et qui est réalisé de telle manière que une ou plusieurs lignes (XSEL1, ..., XSELn) peuvent être sélectionnées en fonction d'une adresse appliquée au bus (5) d'adresse,
- au moins un décodeur (7) d'adresse redondant qui est branché entre le bus (5) d'adresse et les lignes (RXSEL1, ..., RXSEL3) de sélection redondantes et qui est réalisé de telle manière qu'une ou plusieurs lignes (RXSEL1, ..., RXSEL3) de sélection redondantes peuvent être sélectionnées en fonction d'une adresse s'appliquant au bus (5) d'adresse, et
- le circuit de sélection de lignes de sélection redondantes est monté dans la zone du décodeur (7) d'adresse redondant.

8. Mémoire de données suivant la revendication 7, caractérisée en ce que le décodeur (4) d'adresse est réalisé de telle manière qu'il peut être désactivé par le décodeur (7) d'adresse redondant.

9. Mémoire de données suivant la revendication 7 ou la revendication 8, caractérisée en ce qu'elle comporte les caractéristiques suivantes:
- le bus (5) d'adresse est réalisé en bus parallèle ayant une pluralité de lignes (ADR0, ADR1) de bus d'adresse,
- la mémoire (10, 11, 12, 13) d'association comporte des cellules (19, 20) de mémoire d'association, le nombre des cellules (19, 20) de mémoire d'association étant égal au nombre des lignes (ADR0, ADR1) de bus d'adresse.

10. Mémoire de données suivant la revendication 9, caractérisée en ce que la mémoire (10, 11, 12, 13) d'association comporte au moins une cellule (21) de mémoire de validation ayant une ligne (ENA) d'adresse de validation.

11. Mémoire de données suivant l'une des revendications précédentes, caractérisée en ce qu'elle comporte les caractéristiques suivantes :
- le circuit de sélection de lignes de sélection redondantes comporte plusieurs mémoires (10, 11, 12, 13) d'association pour la réception de l'information d'association,
- il est prévu dans la zone des cellules de mémoire d'association des lignes (RSEL) d'adresse d'association, au moins une mémoire (10, 11, 12, 13) d'association pouvant être sélectionnée en appliquant au moins un signal d'association à au moins une ligne (RSEL) d'adresse d'association.

12. Mémoire de données suivant la revendication 6, caractérisée en ce qu'il est prévu au moins un décodeur (15) de sélection de mémoire d'association qui est branché entre un bus (8) d'adresse d'association et les lignes (RSEL) d'adresse d'association et qui est réalisé de telle manière qu'une ou plusieurs lignes (RSEL) d'adresse d'association peuvent être sélectionnées en fonction d'une adresse s'appliquant au bus (8) d'adresse d'association.
